# FASCICULE DE BREVET EUROPEEN

(11) **EP 3 242 537 B1**
(45) Date de publication et mention de la délivrance du brevet: **29.08.2018**
(21) Numéro de dépôt: 17168135.6
(22) Date de dépôt: 26.04.2017
(51) Int. Cl.: H05K 3/02, H05K 3/06, H05K 3/28, H01L 33/62, H05K 1/16

(54) **PANNEAU COMPRENANT UN COMPOSANT ELECTRONIQUE**
PANEEL, DAS EINE ELEKTRONISCHE KOMPONENTE UMFASST
PANEL COMPRISING AN ELECTRONIC COMPONENT

(30) Priorité: 03.05.2016 EP 16305511
(43) Date de publication de la demande: 08.11.2017
(73) Titulaire: SCHOTT VTF, 57870 Troisfontaines (FR)
(72) Inventeur: DE ZORZI, Serge, 57870 Walscheid (FR); KOLHEB, Benoît, 57445 Reding (FR); LONDICHE, Bénédicte, 57400 Sarrebourg (FR)
(74) Mandataire: Kessler, Marc

(56) Documents cités:
- EP-A1- 1 450 416
- EP-A1- 1 933 079
- EP-A1- 1 935 633
- DE-A1-102008 009 775
- US-A1- 2003 150 101
- US-A1- 2010 061 089
- US-B1- 6 270 236

## Description

### Objet de l'invention

La présente invention a trait à un panneau, de préférence en verre, comprenant un ou plusieurs composants électroniques, du type Composants Montés en Surface (CMS), en particulier une ou plusieurs Diode Electro Luminescentes (DEL ou LED), et porte également sur un procédé d'obtention d'un tel panneau.

### Etat de la technique

De nos jours, il est relativement courant d'Intégrer des composants électroniques sur tout type de supports.

Par exemple, et en particulier pour ce qui concerne l'intégration de sources lumineuses, il a été proposé, par le document US 2010/0061089, une bande lumineuse flexible comprenant un motif de pistes conductrices faites de bandes de cuivres, sur lesquelles sont connectées une multitude de LEDs, des pistes conductrices qui sont recouvertes d'une couche isolante.

Dans le domaine des panneaux rigides, en matière plastique ou en verre, il peut également être avantageux de disposer de panneaux intégrant un composé électronique, en particulier une source lumineuse, notamment pour du vitrage, du mobilier urbain, des cloisons, des éléments de sol, des marches d'escalier dans l'aménagement intérieur d'une maison ou d'un appartement, comme portes ou étagères de meuble dans l'ameublement, ou comme éléments d'équipements électroménagers, comme par exemple de cuisinières ou de four de cuisson, comme tablettes de réfrigérateurs.

Ainsi, sont bien connus, des panneaux rigides lumineux, généralement en verre, comprenant, ou intégrant, un éclairage, permettant d'illuminer les objets disposés sur de tels panneaux ou disposés dans les dispositifs comprenant de tels panneaux.

Généralement, ces panneaux lumineux comprennent un ou plusieurs dispositifs lumineux, éventuellement avec leur alimentation électrique, une batterie par exemple, posés ou fixés sur une des surfaces des panneaux. Toutefois, ces panneaux lumineux sont bien souvent disgracieux et une fois les panneaux lumineux encombrés d'objets, l'efficacité des dispositifs lumineux est bien souvent réduite.

Pour remédier à cela, il a alors été proposé des panneaux rigides lumineux dont le ou les dispositifs lumineux sont disposés, non plus sur la surface des panneaux, mais sur un ou plusieurs bords des panneaux.

Ainsi, pour des appareils électroménagers, en particulier des réfrigérateurs, il a été proposé de disposer les dispositifs lumineux dans un cadre, ou garniture, venant engager les bords d'un panneau support en verre.

Par exemple, le document US7434951 décrit une tablette comprenant un panneau en verre dont les bords engagent une garniture permettant la fixation de la tablette à l'intérieur d'un réfrigérateur, une garniture qui comprend un dispositif lumineux sous la forme d'un tube lumineux et des connecteurs électriques pour alimenter le dispositif lumineux. Toutefois, cette solution présente l'inconvénient d'être complexe à produire et encombrante du fait de la présence de la garniture. Par ailleurs, cette solution n'est pas d'un usage universel car l'intégration d'un tel panneau ou tablette dans un dispositif ou système, comme un meuble ou un équipement électroménager nécessite l'emploi d'un rack spécifique recevant la tablette.

Il existe également des panneaux rigides lumineux moins encombrants.

Par exemple, le document EP0900971 décrit un panneau lumineux comprenant un support en verre comprenant des bandes conductrices, faites d'une couche conductrice, sur lesquelles sont disposées des LEDs, les bandes étant réalisées à l'aide d'un masque, reprenant le motif des bandes à imprimer sur le support, lors de l'application de la couche conductrice.

Toutefois, ce type de panneaux présente l'inconvénient d'être inesthétiques de par la présence du motif formé par la multitude de bandes conductrices disposées sur le support en verre. C'est pourquoi, il a été alors proposé une autre solution plus esthétique, dans laquelle les pistes conductrices sont moins visibles.

Par exemple, le document EP1450416 décrit un substrat de support transparent, pouvant être du verre, comprenant une couche conductrice transparente, à base d'un métal ou oxyde de métal conducteur, recouvrant toute la surface du support et déposée par dépôt chimique en phase vapeur (CVD) ou dépôt physique en phase vapeur (PVD), à base d'un métal ou oxyde de métal conducteur. La couche conductrice est structurée, en au moins deux pistes distinctes conductrices, séparées par au moins une bande isolante formée par une découpe LASER de la couche conductrice, puis des diodes sont appliquées sur la couche conductrice à l'aide d'une pâte de soudure, une des bornes des diodes étant en contact avec une piste conductrice, l'autre borne étant en contact avec l'autre piste conductrice. Le document US20030150101 décrit un circuit imprimé. où la résistance du résistor est ajustée par formation des lignes de rupture dans la couche du résistor formées par laser.

Ce type de panneaux est utilisé comme dispositif d'affichage, comme par exemple un écran vidéo, comme décrit dans le document DE102008009775.

Ces panneaux rigides présentent l'inconvénient, pour un support donnée et une couche conductrice donnée, de ne pas être adaptés, ou facilement adaptables, au(x) composé(s) électronique(s) à intégrer. Par conséquent, il est alors nécessaire soit d'adapter la nature et/ou l'intensité de la source électrique et/ou d'ajouter des composés électroniques afin d'obtenir une tension de régulation adéquate pour le ou les composés électroniques considérés. De plus, l'ajout de composants, des résistances, de régulation altère l'esthétique des panneaux, notamment des panneaux transparents ou translucides.

Par ailleurs, ces panneaux rigides présentent l'inconvénient, lors de leur usage, de ne pas permettre de recevoir sur leur surface des objets ou des éléments métalliques ou des conducteurs, comme de l'eau ou de l'humidité, en garantissant le maintien de la fonction du composé électronique.

### Buts de l'invention

La présente invention vise à fournir un panneau comprenant sur l'une de ces surfaces un ou plusieurs composants électroniques et une méthode de fabrication d'un tel panneau, qui ne présentent pas les inconvénients de l'état de la technique.

La présente invention vise à fournir une alternative aux solutions de l'état de la technique existantes.

La présente invention vise également à fournir un panneau comprenant sur l'une de ces surfaces un ou plusieurs composants électroniques, qui soient d'un usage universel dans de nombreux domaines, et permettant la réalisation de la fonction du ou des composants électroniques en toutes circonstances.

### Résumé de l'invention

La présente invention porte sur un panneau rigide comprenant au moins une surface, une couche conductrice, faite d'un matériau conducteur et recouvrant la surface, à l'exception d'au moins une bande isolante de 1nm à 5 mm de large, la bande isolante délimitant ainsi dans la couche conductrice au moins deux conducteurs de tension, chacun étant en contact électrique avec au moins une des bornes d'un ou plusieurs composants électroniques et avec des moyens d'alimentation en électricité du ou des composants électroniques, la couche conductrice d'un ou plusieurs des conducteurs de tension comprenant une ou plusieurs lignes de rupture dans son épaisseur dans laquelle ou lesquelles ladite surface ne comprend pas de matériau conducteur.

Selon des modes préférés de l'invention, le panneau selon l'invention comprend au moins une, ou une combinaison quelconque appropriée, des caractéristiques suivantes :
- Ja ou les lignes de rupture dans l'épaisseur de la couche conductrice communiquent avec et s'étendent à partir d'un ou plusieurs points de la ou des bandes isolantes,
- le panneau comprend en outre une couche isolante recouvrant la couche conductrice, la ou les bandes isolantes et la ou les lignes de rupture,
- les au moins deux conducteurs de tension sont en contact électrique avec un ou plusieurs composants électroniques et des moyens d'alimentation en électricité par l'intermédiaire d'une pâte conductrice,
- la pâte conductrice est appliquée sur la couche conductrice,
- le support est fait de verre transparent, la couche conductrice est transparente et comprend de l'oxyde d'étain, la couche isolante est transparente est comprend un ou plusieurs oxydes métalliques non conducteurs et le ou les composants électroniques sont des Diodes Electro Luminescentes,
- les moyens d'alimentation en électricité du ou des composants électroniques comprennent des connecteurs comprenant chacun une pièce conductrice s'engageant dans, et s'étendant au-delà, d'un trou débouchant pratiqué dans le support,
- le panneau est une tablette de meubles, d'armoires, de commodes, de vitrines ou de réfrigérateurs ou un vitrage d'automobile.

La présente invention porte aussi sur une méthode de fabrication d'un panneau comprenant un ou plusieurs composants électroniques comprenant au moins une borne de connexion et des moyens d'alimentation en électricité dudit ou desdits composants électroniques, en particulier le panneau selon l'invention, la méthode comprenant les étapes de prendre un support rigide comprenant au moins une surface et la recouvrir d'une couche conductrice, faite d'un matériau conducteur, ou de prendre un support déjà recouvert d'une couche conductrice sur au moins une surface, et comprenant éventuellement des moyens d'alimentation en électricité, de structurer la couche conductrice pour former au moins deux conducteurs de tension, au moyen d'au moins une bande isolante, de 1nm à 5 mm de large, pratiquée dans l'épaisseur de la couche conductrice, et dans laquelle la ou les surfaces du support est dépourvue de tout matériau conducteur,
- réaliser les moyens d'alimentation en électricité si le support n'en comprend pas déjà, et les mettre en contact électrique avec les au moins deux conducteurs de tension, de mettre en contact électrique la au moins une borne du ou des composants électroniques avec les au moins deux conducteurs de tension, de réaliser, dans la couche conductrice d'un ou plusieurs des conducteurs de tension, une ou plusieurs lignes de rupture dans laquelle ou lesquelles la ou les surfaces du support ne comprennent pas de matériau conducteur.

Selon des modes préférés de l'invention, la méthode selon l'invention comprend au moins une, ou une combinaison quelconque appropriée, des caractéristiques suivantes :
- la ou les lignes de rupture sont réalisées de manière à ce que la ou lignes de rupture communiquent avec et s'étendent à partir d'un point de la ou des bandes isolantes,
- la méthode comprend en outre une étape de pose d'une couche isolante recouvrant la couche conductrice, la ou les bandes isolantes et la ou les lignes de rupture,
- la méthode comprend en outre le dépôt d'une pâte conductrice aux endroits du support, de la couche conductrice, la pâte conductrice étant destinés à recevoir le ou les composants électroniques et/ou au niveau des moyens d'alimentation en électricité, éventuellement suivi d'un traitement thermique de la pâte conductrice,
- l'étape de dépôt de la couche isolante, si cette dernière est présente, est réalisée avant l'étape de dépôt de la pâte conductrice et son traitement thermique,
- l'étape de dépôt de la couche isolante, si cette dernière est présente, est réalisée après une étape de traitement thermique de la pâte conductrice et avant une étape d'élimination de la couche isolante n'ayant pas adhérée à la pâte conductrice traitée thermiquement, suivie par la mise en contact électrique du ou des composants électroniques,
- l'étape de réalisation des moyens d'alimentation en électricité comprend la réalisation de connecteurs par engagement de pièces conductrices dans des trous débouchant pratiqués dans le support.

### Brève description des figures

La figure 1 est une représentation schématique d'une vue de profil d'un mode de réalisation du panneau selon l'invention.
La figure 2 est une représentation schématique d'une vue du dessus du mode de réalisation représenté à la figure 1.
La figure 3 est une représentation schématique d'une vue du dessus d'un second mode de réalisation du panneau selon l'invention.

### Description détaillée de l'invention

Le panneau 1 selon la présente invention est rigide et il est apte à supporter le poids d'un ou plusieurs objets sans fléchir sensiblement. Il comprend un support 2, comprenant une couche conductrice 3, un ou plusieurs composants électroniques 4, des moyens 5 d'alimentation du ou des composants électroniques 4 en électricité, et éventuellement, une couche isolante 6.

Le support 2 est rigide, inflexible. Il présente une résistance mécanique à des sollicitations de flexion et/ou de torsion suffisant pour ne pas se déformer sous l'action d'une force de flexion et/ou de torsion. Le support 2 est sensiblement plan, et comprend au moins une première surface 7, de préférence une seconde surface 8, opposée à ladite première surface 7. De préférence, le support 2 est de forme parallélépipédique, mais en fonction de l'utilisation finale du panneau 1, il peut avoir toutes les formes adéquates.

Le support 2 est de préférence transparent, semi-transparent ou opaque, ou bien partiellement transparent, semi-transparent ou opaque. Il peut être sablé et/ou sérigraphie et/ou coloré.

De préférence, le support 2 est, ou comprend, du plastique, du verre, une matière cristalline ou semi-cristalline, une céramique ou une vitrocéramique.

Dans un mode de réalisation préféré de l'invention, le support 2 est une céramique, de préférence, à base d'oxyde d'yttrium Y₂O₃, ou une céramique tel que le grenat d'yttrium-aluminium dopé au néodyme.

Dans un mode de réalisation préféré de l'invention, le support 2 est du verre, de préférence, un verre sodocalcique transparent ou teinté dans la masse, éventuellement à couches diverses, telles que anti-bactériennes, anti-réfléchissantes, par exemple du type connu sous la marque Matelux®, chromées, à faible émissivité, par exemple du type connu sous le nom de Planibel Clear ou de Planibel low-E IsoComfort, commercialisé par la société AGC, ou un borosilicate par exemple connu sous la marque Borofloat® 33. De préférence, le verre est à forte teneur en SiO₂, une teneur avantageusement comprise entre 69% et 81% en poids et avec une transmission lumineuse pouvant aller jusqu'à 90%. Le verre peut avoir éventuellement préalablement subi un traitement thermique du type durcissement, recuit, trempe, bombage.

De préférence, le support 2 a des dimensions et une épaisseur adéquates, qui sont fonctions de l'utilisation finale du panneau 1 selon l'invention. Par exemple, le support 2 peut avoir des dimensions comprises entre 100x200 mm et 2000x1100 mm et une épaisseur comprise entre 3 et 10 mm.

Le support 2 comprenant sur une de ces surfaces 7 ou 8, de préférence sur ces deux surfaces 7 et 8, une couche conductrice 3 recouvrant la totalité de ladite ou lesdites surface 7 et/ou 8 du support 2, à l'exception d'une ou plusieurs bandes isolantes 9 et éventuellement également à l'exception des moyens 5 d'alimentation du ou des composants électroniques 4 en électricité.

De préférence, la couche conductrice 3 supporte, sans modifications majeures de ces propriétés physiques, chimiques et électriques, un éventuel traitement thermique à des températures comprises entre 600 et 1000°C.

De préférence, la couche conductrice 3 est transparente, semi-transparente ou translucide. De préférence, elle comprend, ou est constituée, d'un ou plusieurs oxydes d'un ou plusieurs métaux ou alliages de métaux conducteurs. Avantageusement, la couche conductrice 3 comprend au moins de l'oxyde d'étain de formule SnO₂ ou de l'oxyde d'indium dopé à l'étain, du type In₂O₃ :Sn. Néanmoins, il peut également s'agir de FTO (SnO₂: F) ou ATO (SnO: Sb), ou oxyde de zinc dopé à l'aluminium (ZnO :Al) ou à l'indium (ZnO :In).

De préférence, la couche conductrice 3 comprend, ou est constituée, de SnO₂, qui présente l'avantage d'une forte conductivité électrique, d'une transmission optique élevée et d'une bonne résistance chimique.

Dans un autre mode de réalisation, la couche conductrice 3 peut être, ou comprendre, un polymère conducteur ou une colle, tel que le polymère commercialisé par la société Heraeus Clevios™ sous les noms SV4 et SV3, stabilisé ou non.

De préférence, la couche conductrice 3 a une épaisseur comprise entre 10 nm et 100 µm, de manière encore préférée entre 300 et 450 nm.

De préférence, la couche conductrice 3 a une résistance de surface variant entre 5 et 25 Ω/carré.

La couche conductrice 3 est structurée. C'est à dire que la couche conductrice 3, en particulier son épaisseur, est discontinue sur le support 2, au niveau d'au moins une bande isolante 9, pratiquée dans l'épaisseur de la couche conductrice 3, une bande 9 dans laquelle la surface 7 ou 8 du support 2 est dépourvue de toute matière conductrice et qui s'étend entre au moins l'endroit destiné à recevoir le ou les composants électroniques 4 et les moyens 5 d'alimentation en électricité, de préférence sur toute la longueur du support 2. La largeur de cette au moins une bande isolante 9 est de préférence la plus petite possible afin d'être peu ou pas visible à l'oeil nu. Avantageusement, cette au moins une bande isolante 9 a une largeur comprise entre 1 nm et 5 mm.

La couche conductrice 3 structurée présente l'avantage de délimiter, sur le support 2, au moins deux conducteurs de tension 10 et 11 distincts, chacun s'étendant entre, et en contact avec, tout ou partie des moyens 5 d'alimentation électrique, et au moins une des bornes de connexion d'un ou plusieurs composants électroniques 4, le premier des deux conducteurs de tension 10 ou 11 correspondant à un pôle électrique positif, le second conducteur 11 ou 10 correspondant à un pôle électrique négatif.

La couche conductrice 3 ainsi structurée, présente l'avantage de former des conducteurs de tension 10 et 11 dont la ou les lignes de démarcation, la ou les bandes isolantes 9, sont peu ou pas visibles à l'oeil nu, et de permettre une grande liberté de disposition du ou des composants électroniques 4 sur le panneau 1. Le ou les composants électroniques 4 et les moyens 5 d'alimentation en électricité, ou l'alimentation électrique, peuvent être regroupés, ou éparpillées, à différents endroits du support 2, et donc de les disposer éloignés les uns des autres, en particulier de disposer le ou les composants électroniques 4 éloignés des moyens 5 d'alimentation en électricité ou de l'alimentation électrique tout en utilisant un circuit électrique peu ou pas visible à l'oeil nu.

Un ou les deux conducteurs de tension 10 et 11 de la couche conductrice 3 est ou sont structurés, ce qui présente l'avantage de pouvoir introduire une résistance de régulation, qui peut être affinée en fonction de l'intensité de fonctionnement du ou des composants électroniques 4, en fonction de la résistance ohmique désirée, permettant ainsi la suppression de l'emploi de composants de résistances. Le panneau 1 selon l'invention ne comprend alors que le ou les composants électroniques 4 désirés ou d'utilité.

La résistance de régulation est obtenu par au moins une, de préférence une multitude de lignes 12 de rupture dans tout ou partie de l'épaisseur de la partie ou des parties de la couche conductrice 3 formant les deux conducteurs de tension 10 et 11. Les conducteurs de tension 10 et 11 ainsi structurés peuvent avoir une taille identique ou bien différente.

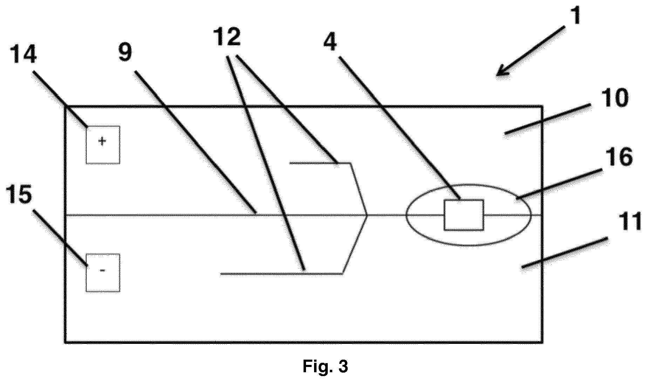

La ou les lignes 12 de rupture dans l'épaisseur de la couche conductrice 3, comme pour la ou les bandes isolantes 9 formant les deux conducteurs de tension 10 et 11, est ou sont de préférence une ou des zones de la surface 7 ou 8 du support 2, dépourvues de matière conductrice ; toutefois, contrairement aux bandes isolantes 9, les lignes 12 de rupture ne s'étendent pas sur toute la longueur et/ou largeur de la couche conductrice 3 et ne délimitent pas deux autres connecteurs de tension dans le ou les connecteurs de tension 10 et 11. Soit la ou les lignes 12 de rupture, par l'intermédiaire d'une ou de ces deux extrémités, communiquent avec et s'étendent à partir d'un ou plusieurs points de la ou des bandes isolantes 9 sur une partie de la longueur et/ou une partie de la largeur de la couche conductrice 3 du ou des conducteurs de tension 10 et 11 texturés (figure 3), soit la ou les lignes 12 de rupture ne communiquent pas avec la ou les bandes isolantes 9. Il est également possible d'avoir une ou plusieurs lignes 12 de rupture communicantes avec la bande isolante 9 et une ou plusieurs autres lignes 12 de rupture ne communiquant pas avec la bande isolante 9.

De préférence, la ou les lignes 12 de rupture sont les moins larges possible, ce qui présente l'avantage d'être peu ou pas visible à l'oeil nu. Avantageusement, la ou les lignes 12 de rupture ont une largeur comprise entre 1 nm et 5 mm.

Par exemple, si la résistance désirée de la couche conductrice 3 est de 75 ohms, la réalisation des au moins deux conducteurs de tension 10 et 11 conduit à obtenir une résistance de 50 ohms, la structuration supplémentaire des deux conducteurs de tension 10 et 11 (figure 3) permet d'atteindre la valeur désirée de 75 ohms.

La ou les au moins deux conducteurs de tension 10 et 11, structurées par une ou des lignes 12 de rupture dans l'épaisseur de la partie ou les parties de la couche conductrice 3 formant les deux conducteurs de tension 10 et 11, présentent également l'avantage de réduire l'intensité d'un éventuel court-circuit pouvant se produire, par exemple, lorsqu'un objet ou élément métallique ou un conducteur, comme de l'eau ou de l'humidité, vient en contact avec les au moins deux conducteurs de tension 10 et 11. La couche conductrice 3 des conducteurs de tension 10 et 11 réagit alors comme une résistance chauffante dont la puissance varie selon l'endroit du court-circuit. Ainsi, les lignes 12 de rupture présentent l'avantage de pouvoir dissiper un éventuel court- circuit et donc de se passer d'une couche isolante devant recouvrir la couche conductrice ou de réduire l'emploi de cette dernière seulement à certaines portions de la couche conductrice 3 ou du panneau 1 selon l'invention.

Que les au moins deux conducteurs de tension 10 et 11 soient structurés par une ou des lignes 12 de rupture, ou pas, le panneau 1 selon l'invention peut comprendre en outre une couche isolante 6 recouvrant tout ou partie de la couche conductrice 3 et éventuellement le support 2 au niveau de la bande isolante 9 et de la ou des lignes 12 de rupture. L'emploi de la couche isolante 6 présente l'avantage de permettre au panneau 1 selon l'invention de garantir le fonctionnement du ou des composants électroniques 4 qu'il comprend, même lorsque le panneau 1 reçoit sur sa surface un objet métallique ou un conducteur, comme par exemple de l'eau ou de l'humidité.

Le mode de réalisation dans lequel le panneau 1 comprend au moins deux conducteurs de tension 10 et 11 structurées et une couche isolante 6 les recouvrant présente l'avantage d'obtenir un panneau 1 isolé de tout élément conducteur extérieur au panneau 1, protégé des courts-circuits qui pourraient résulter du contact avec objet métallique ou conducteur, et ayant une résistance de régulation, sans l'emploi de composants de résistances, de préférence une résistance de régulation ajustée, avantageusement ajustée finement, en fonction de l'intensité de fonctionnement du ou des composants électroniques 4 et/ou en fonction de la résistance ohmique désirée.

La couche conductrice 3 pouvant recouvrir une ou les deux surfaces 7 et 8 du support 2, la couche isolante 6 peut recouvrir la couche conductrice d'une, de préférence des deux surfaces 7 et 8, de préférence à l'exception du ou des composants électroniques 4 et de la colle ou pâte conductrice 13, et avantageusement également à l'exception des moyens 5 d'alimentation du ou des composants électroniques 4 en électricité.

De préférence, la ou les couches isolantes 6 sont transparentes ; néanmoins, elles peuvent être semi-transparentes, ou partiellement transparentes, semi-transparentes ou opaques, éventuellement également être sérigraphiées et/ou colorées.

De préférence, la ou les couches isolantes 6 comprennent, ou sont constituées, d'un ou plusieurs oxydes métallique non conducteur. Il peut s'agir de composés à base de titane tel que TiO₂, ou d'oxyde de silicium SiO₂, ou encore un composé de type Ca₂O₃. De préférence, il s'agit d'oxyde de silicium (SiO₂).

De préférence, la ou les couches isolantes 6 possèdent des propriétés mécaniques, chimiques ou thermiques d'intérêt. Ainsi, la ou les couches isolantes 6 peuvent avoir des propriétés hydrophobes et/ou oléophobes, hydrophiles et/ou oléophiles, photocatalytiques, antisalissures, anti-solaires, antireflets et/ou thermiquement isolantes.

De préférence, l'épaisseur de la ou les couches isolantes 6 est comprise entre 0.01 et 400 *µ*m, ce qui présente l'avantage d'avoir un panneau 1 ayant une épaisseur correspondante à celle d'un panneau en verre classiquement utilisé.

Le ou les composants électroniques 4 comprennent ou sont tous composants adéquats destinés à conférer au panneau 1 selon l'invention une fonctionnalité particulière et/ou dédiés à une ou plusieurs applications. Il s'agit de Composants Montés en Surface (CMS). Il peut s'agir par exemple de condensateurs, de diodes, de circuits intégrés et/ou de résistances.

Dans un mode de réalisation particulier, le ou les composants électroniques 4 comprennent ou sont une ou plusieurs diodes électroluminescentes. De préférence, il s'agit de des diodes électroluminescentes à diffusion perpendiculaire ou angulaire de couleur fixe ou variable.

Le ou les composants électroniques 4 sont disposés directement sur le support 2, ou directement sur la couche conductrice 3, ou bien sur une pâte conductrice 13, cette dernière pouvant être déposée sur la couche conductrice 3, de préférence une pâte conductrice 13 ayant préalablement subi un traitement thermique ou vitrification. Le ou les composants électroniques sont en contact avec au moins les deux conducteurs de tension 10 et 11 de la couche conductrice 3, une des bornes de connexion du ou des composants électroniques 4 étant en contact avec une des deux conducteurs 10 ou 11 et l'autre borne de connexion étant en contact avec l'autre des deux conducteurs 10 ou 11. La couche conductrice 3 pouvant être divisée en une multitude de conducteurs de tension 10 et 11, les composants électroniques 4 pouvant alors être connectés en série. Des dispositions mixtes, série et parallèle, peuvent aussi être prévues.

Le ou les composants électroniques 4 sont fixés au support 2, ou à la couche conductrice 3, et en contact électrique avec la couche conductrice 3 par tous moyens adéquats, de préférence par l'emploi d'une colle conductrice ou bien d'une pâte conductrice 13, de préférence traitée thermiquement ou vitrifiée. L'emploi d'une pâte conductrice 13 présente l'avantage d'améliorer le contact électrique entre la couche conductrice 3 et le ou les composants électroniques. Avantageusement, l'emploi de la pâte conductrice 13 se fait avec un apport d'un composant de soudure, par exemple de l'étain, ce qui améliore la qualité de la soudure. L'emploi d'une colle conductrice présente également l'avantage de permettre ce même contact électrique, sans avoir besoin d'avoir recours à une soudure et donc à un chauffage et permet également d'encapsuler le ou les composants électroniques 4.

De préférence, la colle est du type mono-composant à base d'acrylate, avantageusement durcissable par son exposition à un rayonnement UV et/ou UVA lumière visible, telle que, par exemple, la colle connue sous la marque Delo-Photobond® AD414 et commercialisée par la société DELO, ou une colle à base de résine époxy, de préférence comprenant des charges métalliques, avantageusement de l'Argent, comme par exemple la colle commercialisée sous le nom Elecolit® 3012.

De préférence, la pâte conductrice 13 est à base d'argent, avec plus de 50% en poids de solide. Avantageusement, elle comprend également du terpinéol anhydre. A titre d'exemple, il peut s'agit de la pâte connue sous la dénomination S2028 F de la société Metalor®, comprenant en outre de la colophane et du cyclohexanol. La pâte conductrice 13 peut comprendre 50 à 100% en poids d'argent, de 10 à 20% en poids de terpinéol anhydre, de 2,5 à 10% en poids de formaldéhyde, de 2,5 à 10 de bore, et moins de 2,5% en poids de sulfate de cuivre pentahydrate. Avantageusement, il s'agit de la pâte d'argent sans plomb connue sous la dénomination A-6474AP de la société Metalor®. A titre subsidiaire, la pâte conductrice 13 peut également être la pâte connue sous la dénomination LPA 410-117 de la société Heraeus.

Les moyens 5 d'alimentation du ou des composants électroniques 4 en électricité comprennent tous moyens permettant de lier électriquement le ou les composants électroniques 4 à une source d'électricité, de préférence basse tension, une source qui de préférence ne fait pas partie du panneau 1 selon l'invention.

Les moyens 5 d'alimentation peuvent, par exemple, comprendre des fils conducteurs.

Dans un mode de réalisation particulier, ces moyens 5 comprennent au moins deux connecteurs 14 et 15, dont l'un est en contact électrique avec l'un des conducteurs 10 ou 11 de la couche conductrice 3 et l'autre est en contact électrique avec l'autre des conducteurs 10 ou 11.

De préférence, les connecteurs 14 et 15 des moyens 5 d'alimentation sont disposés sur le support 2, à l'extrémité opposée de celle où se trouve le ou les composants électroniques 4.

De préférence, les connecteurs 14 et 15 des moyens 5 d'alimentation permettent d'alimenter en électricité, de façon concomitante, les deux surfaces 7 et 8 du support 2. Dans un mode de réalisation particulier, les connecteurs 14 et 15 comprennent, ou sont constitués, chacun par une pièce conductrice, de préférence une pièce métallique, s'engageant dans, et s'étendant au delà, d'un trou débouchant pratiqué dans le support 2 et soudée, au support 2 ou à la couche conductrice 3, par une pâte conductrice 13, de préférence une pâte à base d'argent avec plus de 50% de solide. Ce mode de réalisation présente l'avantage de permettre d'alimenter en électricité les deux surfaces 7 et 8 d'un même support 2.

Le panneau 1 selon l'invention peut comprendre en outre une ou plusieurs couches supplémentaires lui conférant des propriétés particulières, en plus de celle(s) conférée(s) par le ou les composants électroniques 4. Cette ou ces couches supplémentaires peuvent recouvrir tout ou partie du panneau 1, et peuvent recouvrir en particulier le ou les composants électroniques 4.

A titre d'exemple, le panneau 1 peut comprendre une couche d'un matériau hydrophobe et/ou oléophobe, hydrophile et/ou oléophile, photocatalytique, antisalissure, réfléchissant le rayonnement thermique ou infra rouge (bas-émissif) et/ou antireflet.

Dans un mode de réalisation particulier du panneau 1 selon l'invention, indépendamment de la présence d'une couche supplémentaire telle que décrite précédemment, le ou les composants électroniques 4 peuvent être recouverts d'un revêtement étanche 16, comprenant ou constitué d'une résine, ou d'une colle, transparente. La résine permet d'enrober et d'encapsuler le ou les composants électroniques 4 de manière à assurer une protection contre l'humidité, ainsi que les contraintes thermiques et extérieures. La colle, quant à elle, permet d'assurer à la fois l'assemblage du ou des composants électroniques 4 et sa protection contre l'environnement extérieur. En fonction du choix du revêtement étanche 16, le procédé d'application pourra être différent.

De préférence, la colle utilisée comme revêtement étanche 16 est une colle UV acrylate mono-composant. De préférence, elle comprend de 25 à 100% en poids de 2-acetoxyethylmethacrylate, de 10 à 25% en poids d'isobornyl acrylate, de 10 à 25% en poids de polytétramethyler-éthylène-glycol-dimethacrylate, de 10 à 25% en poids d'acide méthacrylique, moins de 3% en poids de béta-carboxyléthylacrylate, plus de 2,5% en poids d'oligomères d'acide acrylique et moins de 1% en poids d'acide acrylique. Avantageusement, il s'agit de la colle connue sous la marque Delo-Photobond® 4302 de la société DELO. Toutefois, il peut également s'agir de la colle connue sous la marque Delo-Photobond® GB368. La colle peut également être à base résine epoxy mono-composant telle que par exemple la résine connu sous la marque Delo-Katiobond® OB642.

De préférence, l'épaisseur du panneau 1 rigide selon l'invention, à savoir l'épaisseur du support 2 et de la couche conductrice 3 et éventuellement également la couche isolante 6, est comprise entre 3 et 12 mm.

Le panneau 1 rigide selon l'invention présente l'avantage de supporter un nettoyage, et en particulier d'être nettoyable en lave-vaisselle, qu'il comprenne ou non une couche isolante 6.

Le panneau 1 rigide selon l'invention peut être utilisé dans le domaine de l'aménagement intérieur ou extérieur, comme cloisons ou marches d'escaliers par exemple, comme vitrage d'aquarium, dans le domaine des appareils électroménagers, comme portes de cuisinières, de fours ou de réfrigérateurs, ou tablettes de réfrigérateur, ou bien encore dans le domaine de l'ameublement, comme tablette de meubles, d'armoires, de commodes ou de vitrines, dans le domaine des équipements sanitaires, comme éléments de douche, dans le domaine de l'automobile, par exemple comme vitrages ou toits panoramiques, ou dans les milieux humides, comme éclairage d'aquariums par exemple.

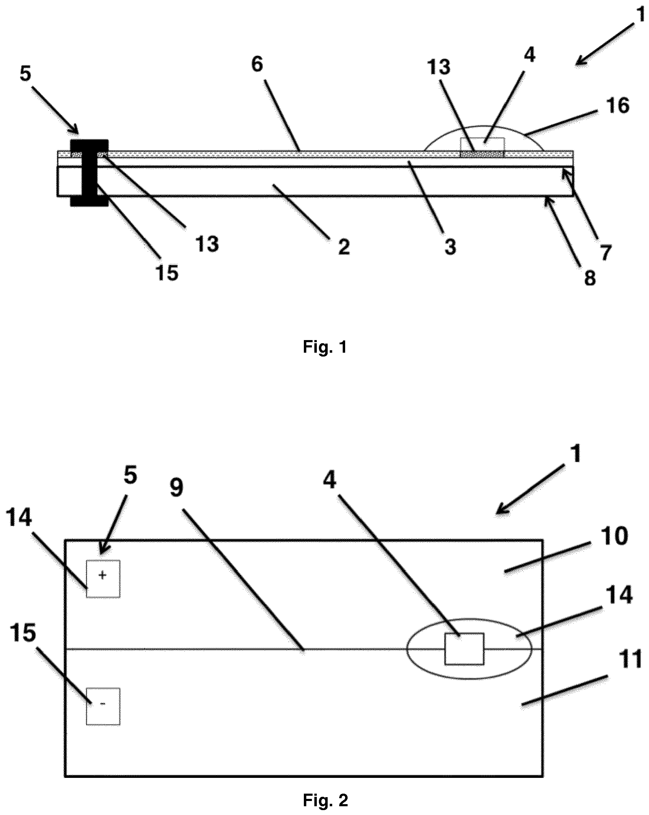

Le panneau 1 rigide selon l'invention est décrit maintenant pour un mode de réalisation particulier de l'invention représenté aux figures 1 à 3, dans lequel le panneau 1 selon l'invention est un panneau lumineux. Le support 2, fait de verre transparent, est de forme parallélépipédique, de 478 mm de long et de 359 mm de large et d'une épaisseur comprise entre 3 et 5 mm, Le support 2 est recouvert, sur l'une de ces surfaces, d'une couche conductrice 3 transparente, à base d'oxyde d'étain (SnO₂), d'une épaisseur entre 350 et 400 nm, divisée, en deux conducteurs de tension 10 et 11 distincts, par une bande isolante 9, un sillon, d'une profondeur égale à l'épaisseur de la couche conductrice 3, ne comprenant pas de matériaux conducteur, et d'une largeur de 1 mm. Les deux conducteurs de tension 10 et 11 peuvent être structurées par des lignes 12 de rupture des sillons, d'une profondeur égale à l'épaisseur de la couche conductrice 3, dans lesquelles la surface 7 ou 8 du support 2 ne comprend pas de matériaux conducteur, afin d'atteindre une résistance de 90 ohms. A l'une des extrémités de panneau 1 est fixée, sur la couche conductrice 3, une diode électroluminescente par l'intermédiaire d'une pâte conductrice 13 à base d'argent, avec environ 82% en poids de solide. A l'autre extrémité du panneau 1, de part et d'autre de la bande isolante 9 séparant les conducteurs de tension 10 et 11, le support 2 est percé de deux trous débouchant recevant des pièces métalliques formant les connecteurs 14 et 15, les pièces métalliques et les conducteurs de tension 10 et 11 respectifs étant mis en contact électrique par l'intermédiaire d'une pâte 13 à base d'argent. La couche conductrice 3 et le support 2 au travers de la bande isolante 9 et des lignes de rupture 12, sont recouverts d'une couche isolante 6 transparente d'oxyde de silicium, à l'exception des connecteurs 14 et 15 et de la diode électroluminescente. Cette dernière est recouverte d'une colle UV acrylate mono-composant.

Ce mode de réalisation particulier de l'invention, avec éventuellement une couche transparente hydrophobe et/ou oléophobe, hydrophile et/ou oléophile, photocatalytique, antisalissure, réfléchissant le rayonnement thermique ou infra rouge (bas-émissif) et/ou antireflet, présente l'avantage de permettre à la lumière de la LED de diffuser dans, et au travers, du panneau 1 améliorant ainsi l'éclairage du ou des objets présents sur le panneau 1.

La présente invention a également pour objet un procédé de réalisation d'un panneau 1 rigide selon l'invention.

Le procédé comprend la fourniture d'un support 2, tel que décrit précédemment, puis l'application d'une couche conductrice 3, telle que décrite précédemment, sur la totalité, d'une ou des surfaces du support 2, pour son ou leur recouvrement total. Cette application peut être faite par toute méthode adéquate, par exemple par pyrolyse, voie poudre ou gazeuse, par pulvérisation cathodique par magnétron, par évaporation, sérigraphie ou jet d'encre. Alternativement, le procédé selon l'invention peut prévoir de fournir un support 2 comprenant déjà une couche conductrice 3, et comprenant éventuellement déjà également des moyens 5 d'alimentation du ou des composants électroniques 4 en électricité, en particulier deux trous débouchant et/ou un ou plusieurs composants électroniques 4, déposés sur le support 2 ou sur la couche conductrice 3.

De préférence, le procédé selon l'invention prévoit une étape de dépôt d'une pâte conductrice 13 à l'endroit ou aux endroits destinés à recevoir le ou les composants électroniques 4 et/ou au niveau des moyens 5 d'alimentation du ou des composants électroniques 4 en électricité, en particulier autour des trous débouchant du support 2. La dépose peut se faire par toute méthode adéquate, de préférence par sérigraphie, par voie liquide ou dépôt sous vide. La pâte conductrice 13 peut être déposée directement sur le support 2, de préférence elle est déposée sur la couche conductrice 3, mais elle peut également l'être sur la couche isolante 6.

De préférence, la pâte conductrice 13 subie ensuite un traitement thermique, par exemple une trempe thermique, permettant ainsi d'améliorer sa soudabilité au support 2 ou à la couche conductrice 3.

De préférence, le traitement thermique consiste en une vitrification lors d'une trempe thermique entre 650°C et 750°C, pendant une période comprise entre 1 et 10 minutes, de préférence entre 2 et 5 minutes. Lors de ce traitement, une pellicule se forme sur la surface de la pâte conductrice 13 vitrifiée, probablement due à un phénomène d'oxydation de ladite pâte conductrice 13. Si l'emploi d'un composant de soudure, par exemple d'étain, est envisagé, la pâte conductrice 13 peut être à nouveau soumise à un traitement thermique allant jusqu'à 300°C par exemple au moyen d'une lampe infrarouge ou par un chauffage à l'aide d'air chaud.

La couche conductrice 3 est structurée, ou découpée, afin de délimiter au moins deux conducteurs de tension 10 et 11 distincts. Cette étape comprend la suppression de la matière conductrice de la couche conductrice 3 du support 2 entre au moins l'endroit destiné à recevoir le ou les composants électroniques 4 et les moyens 5 d'alimentation en électricité, de préférence sur toute la longueur du support 2, pour former au moins une bande 9 isolante, de préférence ayant une largeur comprise entre 1nm et 5 mm. Cette suppression de matière peut être mécanique ou chimique.

De préférence, une ablation par LASER est utilisée, ce qui présente l'avantage d'obtenir une structuration de la couche conductrice 3 peu visible à l'oeil nu, avec un minimum d'altération du support 2.

Le procédé selon l'invention peut comprendre en outre une étape supplémentaire de structuration, ou de découpe, d'un ou plusieurs des conducteurs de tension 10 et 11, afin de réduire leur taille et obtenir ainsi une valeur de résistance électrique désirée, qui est choisie notamment en fonction du ou des composants électroniques 4 du panneau 1. Comme pour la formation de la ou les bandes isolantes 9, cette étape comprend la réalisation d'une ou plusieurs lignes 12 de rupture dans l'épaisseur de la partie ou les parties de la couche conductrice 3 formant les deux conducteurs de tension 10 et 11, des lignes 12 dans lesquelles une ou plusieurs zones du support 2 des conducteurs de tension 10 et 11 sont dépourvues de matière conductrice. Cette suppression de matière conductrice au sein d'un ou des conducteurs de tension 10 et 11 peut être mécanique ou chimique, de préférence il s'agit d'une ablation par LASER. De préférence, les lignes 12 de rupture ont une largeur de 1nm à 5 mm. Avantageusement, la ou les lignes 12 de rupture dans l'épaisseur de la couche conductrice 3 du ou des conducteurs de tension 10 et 11 sont pratiquées de manière à ce que la ou lignes 12 de rupture communiquent avec et s'étendent à partir d'un point de la ou des bandes isolantes 9 sur une partie de la longueur et/ou une partie de la largeur de la couche conductrice 3 du ou des conducteurs de tension 10 et 11 ainsi texturés.

De préférence, cette étape supplémentaire de structuration peut s'accompagner de mesures de résistance électrique des conducteurs de tension 10 et 11, réalisées simultanément, ou quasi simultanément, durant la structuration du ou des conducteurs de tension 10 et 11, des mesures qui sont réalisées, de préférence, en temps réel. Cette étape de mesure de résistance électrique des conducteurs de tension 10 et 11 présente l'avantage de pouvoir donner aux au moins deux conducteurs 10 et 11, de préférence à la multitude de conducteurs 10 et 11, de la couche conductrice 3, la résistance voulue, d'approcher la valeur de résistance électrique théorique du ou des composants électroniques 4, tout en tenant compte du matériau utilisé comme support 2 et de sa résistance électrique intrinsèque.

De préférence, les étapes de formation des au moins deux conducteurs de tension 10 et 11 et de la structuration supplémentaire des au moins deux conducteurs de tension 10 et 11 si elle se fait, s'effectuent de préférence après le traitement thermique de la pâte conductrice 13, et ce, afin de réduire les variations de résistance des conducteurs de tension 10 et 11 qui auraient pu avoir lieu lors du traitement thermique de la pâte conductrice 13.

Le procédé comprend également une étape de pose et de fixation du ou des composants électroniques 4, soit sur la couche conductrice 3, par soudure directe ou apport d'un composant de soudure, par exemple d'étain, soit sur la pâte conductrice 13. Les plots conducteurs du ou des composants électroniques 4 sont mis en contact électrique avec respectivement les au moins deux pistes conductrices 10 et 11 de la couche conductrice 3.

De préférence, pour améliorer la soudure du ou des composants électroniques 4, le composant de soudure est une pâte à braser ou pâte à souder, cette dernière étant, de préférence, préalablement chauffée à une température comprise entre 100 et 300 °C avant d'être mise en contact avec les plots conducteurs du ou des composants électroniques 4. A titre d'exemple, il peut s'agir de la pâte SMDLTLFP de Chipquik® ou de la pâte Print SN42 (S42P220A3) de Nordson EFD®.

Le procédé selon l'invention comprend en outre une étape de réalisation des connecteurs 14 et 15, en particulier de pose et de fixation de pièces conductrices dans les trous débouchant du support 2, de préférence par l'intermédiaire de la pâte conductrice 13.

L'étape de dépôt de la couche isolante 6 peut être réalisée avant ou après le dépôt de la pâte conductrice 13, dans le mode de réalisation qui en comprend.

Dans le mode de réalisation dans lequel le dépôt se fait avant celui de la pâte conductrice 13, le traitement thermique, ou vitrification, de cette dernière lui permet de pénétrer au travers de la couche isolante 6 afin de pouvoir réaliser un contact électrique avec la couche conductrice 3.

Dans le mode de réalisation dans lequel le dépôt se fait avant celui de la pâte conductrice 13, il peut se faire à l'aide d'un masque pour que la couche isolante 6 entoure la pâte conductrice 13 sans toutefois la recouvrir. De façon alternative, le dépôt de la couche isolante 6 peut se faire également sur la pâte conductrice 13, qui aura été préalablement traitée thermiquement, afin de la rendre non-adhérente à la couche isolante 6, cette dernière étant ensuite éliminée au niveau de la pâte conductrice 13 par tous moyens adéquats, par exemple par décapage, frottement ou grattage. Ainsi, la couche isolante 6 n'est supprimée qu'au niveau de la pâte e conductrice 13 et donc également au niveau des connecteurs du ou des composants électroniques 4 ou des connecteurs 14 et 15 des moyens 5 d'alimentation en électricité.

Ainsi, la couche isolante 6 est déposée avec une grande précision sur le tour de toute la surface de pâte conductrice 13, quelle que soit sa forme.

De préférence, la ou les couches isolantes 6 sont déposées par pulvérisation cathodique.

La méthode selon l'invention comprend en outre la mise en contact électrique du ou des composants électroniques 4 avec la couche conductrice 3, de préférence, la fixation des plots de connexion dudit ou desdits composants électroniques 4 sur la pâte conductrice 13 vitrifiée et dépourvue de couche isolante 6.

La méthode selon l'invention comprend éventuellement également le dépôt d'un revêtement étanche 16 sur le ou les composants électroniques 4, de préférence une résine ou une colle, telle que décrite précédemment.

La méthode selon l'invention comprend en outre la réalisation des moyens 5 d'alimentation, en particulier des connecteurs 14 et 15.

En particulier, pour le mode de réalisation dans lequel les deux surfaces 7 et 8 du support 2 comprennent une couche conductrice 3, la méthode selon l'invention comprend l'engagement d'une pièce conductrice, de préférence une pièce métallique, dans des trous débouchant pratiqués dans le support 2 et soudée, au support 2 ou à la couche conductrice 3, par une pâte conductrice 13, de préférence une pâte à base d'argent.

La méthode selon l'invention peut comprendre en outre une ou plusieurs étapes de dépôt d'une ou plusieurs couches supplémentaires conférant des propriétés particulières au panneau 1 selon l'invention, en plus de celle(s) conférée(s) par le ou les composants électroniques 4. Il peut s'agir par exemple de propriétés hydrophobes et/ou oléophobes, hydrophiles et/ou oléophiles, photocatalytiques, antisalissures, réfléchissant le rayonnement thermique ou infra rouge et/ou antireflets.

## Revendications

1. Panneau (1) comprenant un support (2) rigide comprenant au moins une surface (7 ou 8), une couche conductrice (3), faite d'un matériau conducteur et recouvrant ladite au moins une surface (7 ou 8) à l'exception d'au moins une bande isolante (9) de 1 nm à 5 mm de large, ladite bande isolante (9) délimitant ainsi dans ladite couche conductrice (3) au moins deux conducteurs de tension (10, 11), chacun étant en contact électrique avec au moins une des bornes d'un ou plusieurs composants électroniques (4) et avec des moyens (5) d'alimentation en électricité dudit ou desdits composants électroniques (4) **caractérisé par** la couche conductrice (3) d'un ou plusieurs desdits conducteurs de tension (10, 11) comprenant une ou plusieurs lignes (12) de rupture dans son épaisseur dans laquelle ou lesquelles ladite surface (7 ou 8) ne comprend pas de matériau conducteur.

2. Le panneau (1) selon la revendication 1, dans lequel la ou les lignes (12) de rupture dans l'épaisseur de la couche conductrice (3) communiquent avec et s'étendent à partir d'un ou plusieurs points de la ou des bandes isolantes (9).

3. Le panneau (1) selon l'une quelconque des revendications précédentes, comprenant en outre une couche isolante (6) recouvrant la couche conductrice (3), la ou les bandes isolantes (9) et la ou les lignes (12) de rupture.

4. Le panneau (1) selon l'une quelconque des revendications précédentes, dans lequel les au moins deux conducteurs de tension (10, 11) sont en contact électrique avec un ou plusieurs composants électroniques (4) et des moyens (5) d'alimentation en électricité par l'intermédiaire d'une pâte conductrice (13).

5. Le panneau (1) selon la revendication 4, dans lequel la pâte conductrice (13) est appliquée sur la couche conductrice (3.

6. Le panneau (1) selon l'une quelconque des revendications précédentes, dans lequel le support (2) est fait de verre transparent, la couche conductrice (3) est transparente et comprend de l'oxyde d'étain, la couche isolante (6) est transparente est comprend un ou plusieurs oxydes métalliques non conducteurs et le ou les composants électroniques (4) sont des Diodes Electro Luminescentes.

7. Le panneau (1) selon l'une quelconque des revendications précédentes, dans lequel les moyens (5) d'alimentation en électricité du ou des composants électroniques (4) comprennent des connecteurs (14 et 15) comprenant chacun une pièce conductrice s'engageant dans, et s'étendant au-delà, d'un trou débouchant pratiqué dans le support (2).

8. Le panneau (1) selon l'une quelconque des revendications précédentes, étant une tablette de meubles, d'armoires, de commodes, de vitrines ou de réfrigérateurs, ou un vitrage d'automobile.

9. Méthode de fabrication d'un panneau (1) comprenant un ou plusieurs composants électroniques (4) comprenant au moins une borne de connexion et des moyens (5) d'alimentation en électricité dudit ou desdits composants électroniques (4), ladite méthode comprenant les étapes suivantes :
- prendre un support (2) rigide comprenant au moins une surface (7 ou 8) et la recouvrir d'une couche conductrice (3), faite d'un matériau conducteur, ou prendre un support (2) rigide déjà recouvert de ladite couche conductrice (3) sur au moins une surface (7 ou 8), et comprenant éventuellement lesdits moyens (5) d'alimentation en électricité,
- structurer ladite couche conductrice (3) pour former au moins deux conducteurs de tension (10, 11), au moyen d'au moins une bande isolante (9), de 1nm à 5 mm de large, pratiquée dans l'épaisseur de ladite couche conductrice (3), et dans laquelle la ou les surfaces (7 ou 8) dudit support (2) est dépourvue de tout matériau conducteur,
- réaliser lesdits moyens (5) d'alimentation en électricité si ledit support (2) n'en comprend pas déjà, et les mettre en contact électrique avec les au moins deux conducteurs de tension (10, 11)
- mettre en contact électrique ladite au moins une borne dudit ou desdits composants électroniques (4) avec lesdits au moins deux conducteurs de tension (10, 11),
- réaliser, dans la couche conductrice (3) d'un ou plusieurs desdits conducteurs de tension (10, 11), une ou plusieurs lignes (12) de rupture dans laquelle ou lesquelles ladite ou lesdites surfaces (7 ou 8) dudit support (2) ne comprennent pas de matériau conducteur.

10. La méthode selon la revendication 9, dans laquelle la ou les lignes (12) de rupture sont réalisées de manière à ce que la ou lignes (12) de rupture communiquent avec et s'étendent à partir d'un point de la ou des bandes isolantes (9).

11. La méthode selon la revendication 9 ou 10, comprenant en outre une étape de pose d'une couche isolante (6) recouvrant la couche conductrice (3), la ou les bandes isolantes (9) et la ou les lignes (12) de rupture.

12. La méthode selon l'une quelconque des revendications 9 à 11, comprenant le dépôt d'une pâte conductrice (13) aux endroits du support (2), de la couche conductrice (3), ladite pâte conductrice (13) étant destinés à recevoir le ou les composants électroniques (4) et/ou au niveau des moyens (5) d'alimentation en électricité, éventuellement suivi d'un traitement thermique de ladite pâte conductrice (13).

13. La méthode selon la revendication 12, dans laquelle l'étape de dépôt de la couche isolante (6), si cette dernière est présente, est réalisée avant l'étape de dépôt de la pâte conductrice (13) et le traitement thermique de ladite pâte conductrice (13).

14. La méthode selon la revendication 12, dans laquelle l'étape de dépôt de la couche isolante (6), si cette dernière est présente, est réalisée après une étape de traitement thermique de la pâte conductrice (13) et avant une étape d'élimination de ladite couche isolante (6) n'ayant pas adhérée à ladite pâte conductrice (13) traitée thermiquement, suivie par la mise en contact électrique du ou des composants électroniques (4).

15. La méthode selon l'une quelconque des revendications 9 à 14, dans laquelle l'étape de réalisation des moyens (5) d'alimentation en électricité comprend la réalisation de connecteurs (14 et 15) par engagement de pièces conductrices dans des trous débouchant pratiqués dans le support (2).

## Patentansprüche

1. Platte (1), umfassend einen steifen Träger (2), umfassend mindestens eine Oberfläche (7 oder 8), eine leitfähige Schicht (3), die aus einem leitfähigen Material besteht und die mindestens eine Oberfläche (7 oder 8) bis auf mindestens einen 1 nm - 5 mm breiten Isolierstreifen (9) abdeckt, wobei der Isolierstreifen (9) in der leitfähigen Schicht (3) also mindestens zwei Spannungsleiter (10, 11) abgrenzt, die jeweils mit mindestens einer der Klemmen von mindestens einer elektronsichen Komponente (4) und mit Stromversorgungsmitteln (5) der mindestens einen elektronischen Komponente (4) in Kontakt steht, **dadurch gekennzeichnet, dass** die leitfähige Schicht (3) des mindestens einen Spannungsleiters (10, 11) mindestens eine Sollbruchlinie (12) in ihrer Dicke umfasst, in der bzw. denen die Oberfläche (7 oder 8) kein leitfähiges Material umfasst.

2. Platte (1) nach Anspruch 1, wobei die mindestens eine Sollbruchlinie (12) in der Dicke der leitfähigen Schicht (3) mit mindestens einem Punkt des mindestens einen Isolierstreifens (9) verbunden ist und sich von diesem aus erstreckt.

3. Platte (1) nach einem der vorstehenden Ansprüche, ferner umfassend eine Isolierschicht (6), die die leitfähige Schicht (3), den mindestens einen Isolierstreifen (9) und die mindestens eine Sollbruchlinie (12) abdeckt.

4. Platte (1) nach einem der vorstehenden Ansprüche, wobei die mindestens zwei Spannungsleiter (10, 11) über eine Leitpaste (13) mit mindestens einer elektronischen Komponente (4) und Stromversorgungsmitteln (5) in elektrischem Kontakt stehen.

5. Platte (1) nach Anspruch 4, wobei die Leitpaste (13) auf die leitfähige Schicht (3) aufgetragen wird.

6. Platte (1) nach einem der vorstehenden Ansprüche, wobei der Träger (2) aus Klarglas besteht, die leitfähige Schicht (3) transparent ist und Zinnoxid umfasst, die Isolierschicht (6) transparent ist und mindestens ein nicht leitfähiges Metalloxid umfasst und es sich bei der mindestens einen elektronischen Komponente (4) um LEDs handelt.

7. Platte (1) nach einem der vorstehenden Ansprüche, wobei die Stromversorgungsmittel (5) der mindestens einen elektronischen Komponente (4) Verbinder (14 und 15) umfassen, die jeweils ein leitendes Stück umfassen, das in eine im Träger (2) ausgebildete durchgehende Öffnung eingreift und sich darüber hinaus erstreckt.

8. Platte (1) nach einem der vorstehenden Ansprüche, bei der es sich um einen Boden für Möbelstücke, Schränke, Kommoden, Schaufenster oder Kühlschränke oder Autoglas handelt.

9. Verfahren zur Herstellung einer Platte (1), umfassend mindestens eine elektronische Komponente (4), die mindestens eine Anschlussklemme sowie Stromversorgungsmittel (5) der mindestens einen elektronischen Komponete (4) umfassen, wobei das Verfahren die Schritte umfasst:
- Vorsehen eines steifen Trägers (2), umfassend mindestens eine Oberfläche (7 oder 8) und Beschichten des Trägers (2) mit einer leitfähigen Schicht (3) aus einem leitfähigen Material, oder Vorsehen eines bereits auf mindestens einer Oberfläche (7 oder 8) mit der leitfähigen Schicht (3) beschichteten Trägers (2), der ggf. auch die Stromversorgungsmittel (5) umfasst,
- Strukturieren der leitfähigen Schicht (3) zur Bildung mindestens eines Spannungsleiters (10, 11) mithilfe mindestens eines 1 nm - 5 mm breiten Isolierstreifens (9) in der Dicke der leitfähigen Schicht (3), und in der die mindestens eine Oberfläche (7 oder 8) des Trägers (2) kein leitfähiges Material aufweist,
- Herstellen der Stromversorgungsmittel (5), sofern diese im Träger (2) noch nicht vorhanden sind, und Kontaktieren der Stromversorgungsmittel (5) mit den mindestens zwei Spannungsleitern (10, 11);
- Herstellen des elektrischen Kontaktes zwischen der mindestens einen Klemme der mindestens einen elektronischen Komponente (4) und den mindestens zwei Spannungsleitern (10, 11),
- Herstellen mindestens einer Sollbruchlinie (12), in der die mindestens eine Oberfläche (7 oder 8) des Trägers (2) kein leitfähiges Material umfasst, in der leitfähigen Schicht (3) von mindestens einem der Spannungsleiter (10, 11).

10. Verfahren nach Anspruch 9, wobei die mindestens eine Sollbruchlinie (12) derart ausgebildet ist, dass die mindestens eine Sollbruchlinie (12) mit einem Punkt des mindestens einen Isolierstreifens (9) verbunden ist und sich davon aus erstreckt.

11. Verfahren nach Anspruch 9 oder 10, ferner umfassend: Aufbringen einer Isolierschicht (6), die die leitfähige Schicht (3), den mindestens einen Isolierstreifen (9) und die mindestens eine Sollbruchlinie (12) abdeckt.

12. Verfahren nach einem der Ansprüche 9 - 11, umfassend Aufbringen einer Leitpaste (13) auf Stellen am Träger (2), an der leitfähigen Schicht (3), wobei die Leitpaste (13) die mindestens eine elektronische Komponente (4) aufnehmen soll, und/oder auf die Stromversogungsmittel (5), ggf. gefolgt durch eine Wärmebehandlung der Leitpaste (13).

13. Verfahren nach Anspruch 12, wobei das Aufbringen der Isolierschicht (6) ggf. vor dem Aufbringen der Leitpaste (13) und der Wärmebehandlung der Leitpaste (13) erfolgt.

14. Verfahren nach Anspruch 12, wobei das Aufbringen der Isolierschicht (6) ggf. nach einer Wärmebehandlung der Leitpaste (13) und vor dem Entfernen der Isolierschicht (6), die an der wärmebehandelten Leitpaste (13) nicht haftet, gefolgt durch elektrisches Kontaktieren der mindestens einen elektronischen Komponente (4).

15. Verfahren nach einem der Ansprüche 9 - 14, wobei das Herstellen der Stromversorgungsmittel (5) umfasst: Herstellen von Verbindern (14 und 15), indem leitfähige Stücke in durchgängige Öffnungen in Eingriff gebracht werden, die im Träger (2) ausgebildet sind.

## Claims

1. Panel (1) comprising a rigid support (2) comprising at least one surface (7 or 8), a conductive layer (3), made from a conductive material and covering said at least one surface (7 or 8) with the exception of at least one insulating strip (9) from 1 nm to 5 mm wide, said insulating strip (9) thus delimiting, in said conducting layer (3), at least two voltage conductors (10, 11), each being in electrical contact with at least one of the terminals of one or several electronic components (4) and with electrical supply means (5) of said electronic component(s) (4), **characterized by** the conducting layer (3) of one or several of said voltage conductors (10, 11) comprising one or several rupture lines (12) in its thickness in which said surface (7 or 8) does not comprise conductive material.

2. The panel (1) according to claim 1, wherein the rupture line(s) (12) and the thickness of the conducting layer (3) communicate with and extend from one or several points of the insulating strip(s) (9).

3. The panel (1) according to any one of the preceding claims, further comprising an insulating layer (6) covering the conducting layer (3), the insulating strip(s) (9) and the rupture line(s) (12).

4. The panel (1) according to any one of the preceding claims, wherein the at least two voltage conductors (10, 11) are in electrical contact with one or several electronic components (4) and electricity supply means (5) via a conductive paste (13).

5. The panel (1) according to claim 4, wherein the conductive paste (13) is applied on the conducting layer (3).

6. The panel (1) according to any one of the preceding claims, wherein the support (2) is made from transparent glass, the conducting layer (3) is transparent and comprises tin oxide, the insulating layer (6) is transparent and comprises one or several non-conducting metal oxides and the electronic component(s) (4) are Light-Emitting Diodes.

7. The panel (1) according to any one of the preceding claims, wherein the electricity supply means (5) of the electronic component(s) (4) comprise connectors (14 and 15) each comprising a conducting part engaging in, and extending past, a through hole formed in the support (2).

8. The panel (1) according to any one of the preceding claims, being a furniture, cabinet, dresser, window or refrigerator, or automobile pane, panel.

9. The method for manufacturing a panel (1) comprising one or several electronic components (4) comprising at least one connection terminal and means (5) for supplying electricity to said electronic component(s) (4), said method comprising the following steps:
- taking a rigid support (2) comprising at least one surface (7 or 8) and covering it with a conducting layer (3), made from a conducting material, or taking a rigid support (2) already covered with said conducting layer (3) on at least one surface (7 or 8), and optionally comprising said electricity supply means (5),
- structuring said conducting layer (3) to form at least two voltage conductors (10, 11), using at least one insulating strip (9), from 1 nm to 5 mm wide, formed in the thickness of said conducting layer (3), and in which the surface(s) (7 or 8) of said support (2) lacks any conducting material,
- producing said electricity supply means (5) if said support (2) does not already comprise them, and placing them in electrical contact with the at least two voltage conductors (10, 11),
- placing said at least one terminal of said electronic component(s) (4) in electrical contact with said at least two voltage conductors (10, 11),
- producing, in the conducting layer (3) of one or several of said voltage conductors (10, 11), one or several rupture lines (12) in which said surface(s) (7 or 8) of said support (2) do not comprise conducting material.

10. The method according to claim 9, wherein the rupture line(s) (12) are made such that the rupture line(s) (12) communicate with and extend from a point of the insulating strip(s) (9).

11. The method according to claim 9 or 10, further comprising a step for placing an insulating strip (6) covering the conducting layer (3), the insulating strip(s) (9) and the rupture line(s) (12).

12. The method according to any one of claims 9 to 11, comprising depositing a conductive paste (13) on the front sides of the support (2), of the conducting layer (3), said conductive paste (13) being intended to receive the electronic component(s) (4) and/or at the electricity supply means (5), optionally followed by a heat treatment of said conductive paste (13).

13. The method according to claim 12, wherein the step for depositing the insulating layer (6), if the latter is present, is done before the step for depositing the conductive paste (13) and the heat treatment of said conductive paste (13).

14. The method according to claim 12, wherein the step for depositing the insulating layer (6), if the latter is present, is done after a heat treatment step of the conductive paste (13) and before a step for eliminating said insulating layer (6) not having adhered to said heat-treated conductive paste (13), followed by placing the electronic component(s) (4) in electrical contact.

15. The method according to any one of claims 9 to 14, wherein the step for producing electricity supply means (5) comprises producing connectors (14 and 15) by engagement of conducting parts in through holes formed in the support (2).
